Europäisches Patentamt

European Patent Office

Office européen des brevets

(19)

(11) Veröffentlichungsnummer: **0 002 790**
**B1**

(12) **EUROPÄISCHE PATENTSCHRIFT**

(45) Veröffentlichungstag der Patentschrift: **19.10.83**

(21) Anmeldenummer: **78101772.8**

(22) Anmeldetag: **19.12.78**

(51) Int. Cl.³: **G 01 R 19/00, H 04 B 3/48, G 01 R 23/16**

(54) Messeinrichtung für eine Frequenzanalyse von Signalpegeln innerhalb eines grossen Dynamikbereiches.

(30) Priorität: **27.12.77 DE 2758154**

(43) Veröffentlichungstag der Anmeldung:
**11.07.79 Patentblatt 79/14**

(45) Bekanntmachung des Hinweises auf die Patenterteilung:
**19.10.83 Patentblatt 83/42**

(84) Benannte Vertragsstaaten:
**BE CH FR GB IT LU NL SE**

(56) Entgegenhaltungen:
**DE - A - 1 516 739**
**DE - A - 2 119 898**
**FR - A - 1 373 665**
**FR - A - 2 068 716**

**REVIEW OF THE ELECTRICAL COMMUNICATION LABORATORIES, Vol. 25, Nr. 9—10 September-Oktober 1877, Tokyo, JP, H. KATO und N. KANMURI: "Millimeter wave level meter", Seiten 949 bis 957**

(73) Patentinhaber: **SIEMENS AKTIENGESELLSCHAFT Berlin und München Wittelsbacherplatz 2 D-8000 München 2 (DE)**

(72) Erfinder: **Schwierz, Theodor Riedweg 11 D-8891 Klingen (DE)**

(56) Entgegenhaltungen:
**PHILIPS TELECOMMUNICATION REVIEW, Vol. 29, Nr. 3, Januar 1971, P. W. L. VAN ITERSON: "An automatically tuned HF receiving system (RO 100 series)", Seiten 89 bis 102**
**SIEMENS ZEITSCHRIFT, Vol. 45, Heft 10, Oktober 1971, München, DE K. BAUERNFEIND et al.: "Frequenzanalysen mit dem Selektiven Pegelmesser D 2040 im Bereich 30 Hz bis 60 KHz", Seiten 655 bis 657**
**SIEMENS ZEITSCHRIFT, Vol. 43, Heft 10, Oktober 1969, München, DE, M. EBISCH et al.: "Pegelmessplatz für den Frequenzbereich 0,1 bis 100 NHz", Seiten 775 bis 778**
**FUNKSCHAU, Vol 41 No. 16, August 1969, Seiten 533 bis 536**
**BRÜEL & KJAER Messgeräte Frequenz Analysator 2010, 26. November 1976**

EP 0 002 790 B1

Meßeinrichtung für eine Frequenzanalyse von Signalpegeln innerhalb eines großen Dynamikbereiches

Die Erfindung bezieht sich auf eine Meßeinrichtung für eine Frequenzanalyse von Signalpegeln innerhalb eines großen Dynamikbereiches, bestehend aus einer Einrichtung zur mehrfachen Umsetzung der Frequenz von Signalen des Eingangsfrequenzbandes mit in Abhängigkeit der Anzahl der Umsetzungen zunehmender Bandbegrenzung in eine Zwischenfrequenzendlage, mit einem die Umsetzerfrequenzen fur durchlaufenden Abtastung eines großen Frequenzbereiches steuerbar erzeugenden Synthesizer, einer in ihrer Verstärkung regelbaren Zwischenverstärkeranordnung und einer Signalpegelauswerte- und -anzeigevorrichtung. Frequenzanalysatoren dieser Art sind beispielsweise durch die Literaturstelle "Brüel & Kjaer Meßgeräte, Frequenzanalysator 2010" vom 26. Nov. 1976 bekannt.

Frequenzanalysatoren können beispielsweise bei Meßeinrichtungen Anwendung finden, die zum Aufspüren von Kleinstsendern für Abhörzwecke dienen. Ein anderes Anwendungsgebiet stellt die Messung terrestrischer Strahlung dar. Zur systematischen Erkundung elektromagnetischer Strahlung innerhalb eines weiten Frequenzbereiches sind insbesondere fliegende Objekte bzw. Raumfahrzeuge gut geeignet. Die relativ schnelle Bewegung, die von Raumfahrzeugen, insbesonders Satelliten, ausgeführt werden, erfordern in diesem Falle ein Empfangssystem, das in extrem kurzen Zeiten eine maximale Auflösung—bis an die physikalischen Grenzen hin—im Frequenz- und Pegelbereich gewährleistet. Die Güte der Meßergebnisse ist mit anderen Worten wesentlich durch die erzielbare geographische, frequenz- und pegelmäßige Auflösung des zu untersuchenden Radiofrequenz-Leistungsdichtespektrums bestimmt.

Das örtliche Auflösungsvermögen ist weitgehend durch die Bahndaten des Raumfahrzeuges und die Antennenbündelung gegeben. Die frequenzmäßige Auflösung wird durch die verfügbare Meßzeit und die abzutastende Radiofrequenzbandbreite bestimmt. Die pegelmäßige Auflösung ist von der zu erwartenden Leistungsdichte der Strahlung am Empfängereingang und vom minimal meßbaren Eingangspegel, bei Zugrundelegung der minimalen Zwischenfrequenzbandbreite abhängig.

Wie einschlägige Untersuchungen zeigen, ist die erforderliche Mindestverweilzeit bei einer bestimmten Frequenz im wesentlichen von der verwendeten Zwischenfrequenzbandbreite (Einschwingen) und der für die Messung des Pegels (großer Dynamikbereich) notwendigen Zeit festgelegt. Bei vorgegebener geographischer Auflösung, das heißt dem Zeitintervall, das' für die Auswertung eines empfangenen Spektrums, bezogen auf einen bestimmten Raumsektor, zur Verfügung steht, läßt sich die Güte der Meßergebnisse nur dadurch optimieren, daß die erforderliche Mindestverweilzeit bei einer bestimmten Frequenz möglichst klein gehalten wird.

Der Erfindung liegt die Aufgabe zugrunde, zur Durchführung einer extrem schnellen Frequenzanalyse von Signalpegeln innerhalb eines großen Dynamikbereiches eine Lösung für eine Meßeinrichtung anzugeben, die bei hohen Selektionseigenschaften eine extrem schnelle automatische Pegelmessung ermöglicht.

Ausgehend von einer Meßeinrichtung der einleitend erwähnten Art wird diese Aufgabe gemäß der Erfindung dadurch gelöst, daß zur Durchführung einer extrem schnellen Frequenzanalyse die Zwischenfrequenz-Verstärkeranordnung aus zwei und mehr hintereinander angeordneten, den verschiedenen Umsetzerstufen zugeordneten selektiven Verstärkern mit zunehmend Kleinerer Bandbreite mit jeweils eigener automatischer, eine Ansprechschwelle aufweisenden Verstärkungsregelung besteht, daß ferner die bei den einzelnen Verstärkern anfallenden Regelgrößen unter Berücksichtigung der vorgegebenen Regelchrakteristiken in einem Addierer aufsummiert sind und daß der Summenwert vom Ausgang des Addierers der Signalpegelauswerte- und Anzeigevorrichtung zugeführt ist.

Zwar ist es bereits aus der DE—A—15 16 739 im Hinblick auf eine Abstimmanzeige bei Rundfunkempfangsgeräten mit großem Regelumfang bekannt, die Regelspannung der automatischen Schwundausgleichsregelung zur Anzeige zu bringen, wobei von einer aufwendigen Regelung mehrerer Empfängerstufen Gebrauch zu machen ist, von denen jedoch im Gegensatz zum Erfindungsgegenstand mindestens eine ohne Schwellenwert arbeiten soll.

Weiterhin ist es auch durch die Literaturstelle Funkschau, 1969, Heft 16, Seiten 533 bis 536 bekannt, beim mehrstufigen ZF-Verstärker eines FM-Stereo-Tuners die Signalanzeige durch Addition der gleichgerichteten Signalausgangspegel der einzelen ZF-Verstärkerstufen herbeizuführen. Diese bekannte Maßnahme würde in ihrer Anwendung bei der Erfindung zu keinem brauchbaren Ergebnis führen, weil hier die hintereinander geschalteten selektiven Verstärker eine stark unterschiedliche Bandbreite aufweisen.

Der Erfindung liegt die Erkenntnis zugrunde, daß sich die Geschwindigkeit der Pegelmessung in einem großen Dynamikbereich dann extrem schnell gestalten läßt, wenn lediglich der letzte selektive Verstärker hinsichtlich seiner Selektivität für die gewünschte frequenzmäßige Auflösung festgelegt wird. Auf diese Weise ist es nämlich möglich, die bei großem Dynamikbereich erforderliche mehrstufige Regelung so zu gestalten, daß die Regelzeit praktisch von der Regelung des letzten, die höchste Selektivität aufweisenden Verstärkers bestimmt wird.

Für eine Optimierung der Frequenzgenauigkeit ist es sinnvoll, die Steuerung des Synthesizers für eine sprunghafte Frequenzänderung in Stufen vorzunehmen, deren Grösse der Bandbreite des im Zuge der Verstärkung des empfangenen Signalpegels an letzter Stelle vorhandenen selektiven Verstärkers, die das spektrale Auflösungsvermögen festlegt, angepaßt ist. Dabei ist der Summenwert am Ausgang des Addierers im Takt des Frequenzwechsels des Synthesizers der Signalpegelauswerte- und Anzeigevorrichtung zugeführt.

Um zu vermeiden, daß bei der Analyse eines größeren Frequenzbereichs Meßfehler durch Auswertung von Spiegelfrequenzen auftreten, ist es zweckmäßig, zwischen den selektiven Verstärkern weitere mit jeweils einer geeigneten Umsetzschwingung fester Frequenz versorgte Umsetzer anzuordnen.

Bei einer bevorzugten Ausführungsform, bei der von einer sprunghaften Frequenzänderung des Synthesizers Gebrauch gemacht wird, weist die Signalpegelauswerte- und anzeigevorrichtung eingangsseitig einen Analog-Digitalumsetzer auf, der gleichfalls im Takt des Frequenzwechsels des Synthesizers gesteuert ist.

Besonders günstig gestalten sich die Verhältnisse, wenn die Regelung der Verstärker jeweils eine logarithmischlineare Charakteristik aufweisen und der Addierer für eine lineare Summation ausgelegt ist.

Bei einer weiteren besonders bevorzugten Ausführungsform weist die automatische Verstärkungsregelung der selektiven Verstärker ein zwischen zwei Verstärkerstufen angeordnetes steuerbares Dämpfungsglied auf. Hierbei ist die das Dämpfungsglied, einen Regelverstärker mit einem zweiten Ausgang für den Addierer und eine Verstärkerstufe umfassende Regelschleife breitbandig ausgeführt. Mit anderen Worten enthält die Regelschleife nicht das die Selektivität des selektiven Verstärkers bestimmende selektive Netzwerk, so daß die Regelung außerordentlich schnell arbeitet.

Um Übersteuerungen der Verstärker und damit Verfälschungen der Meßergebnisse zu unterbinden, weist jeder Regelverstärker eine geeignet bemessene Ansprechschwelle auf.

Anhand eines in der Zeichnung dargestellten Ausführungsbeispiels soll die Erfindung im folgenden noch näher erläutert werden. In der Zeichnung bedeuten

Fig. 1 das Blockschaltbild einer Meßeinrichtung nach der Erfindung

Fig. 2 ein die Arbeitsweise der Schaltung nach Fig. 1 erläuterndes Pegeldiagramm

Fig. 3 das nähere Einzelheiten aufweisende Blockschaltbild eines Synthesizers nach Fig. 1

Fig. 4 das nähere Einzelheiten aufweisende Blockschaltbild einer Steuereinrichtung nach den Fig. 1 und 3.

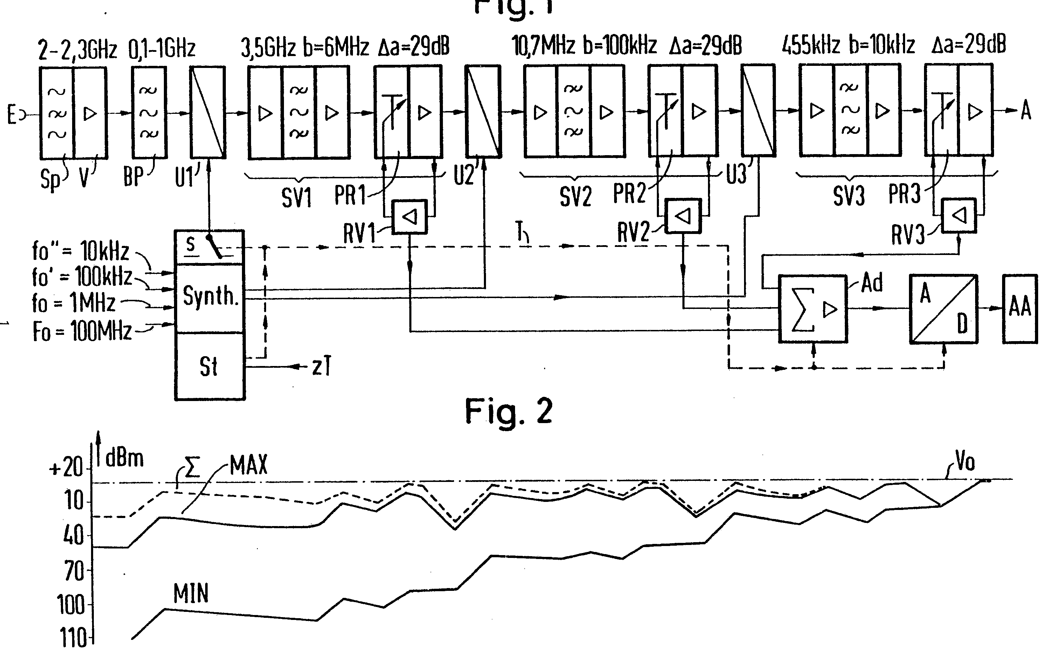

Das Empfangssystem nach Fig. 1, das mit seinem Eingang E mit der Antenne eines Raumfahrzeuges verbunden ist und über diese Antenne in Abhängigkeit ihrer räumlichen Ausrichtung ein hierauf bezogenes Signalspektrum empfängt, ist eingangsseitig mit einer Sperre Sp für die bordeigenen Sender im Frequenzbereich von 2 bis 2,3 GHz und einem breitbandigen Vorverstärker V mit einem nachfolgenden Bandpaß BP für den zu untersuchenden Frequenzbereich von 0,1 bis 1 GHz ausgestattet. Das verstärkte Signal wird dem Umsetzer U1 zugeführt. Der Umsetzer U1 erhält seine Umsetzschwingung von dem durch die Steuereinrichtung ST gesteuerten Synthesizer Synth. Der Synthesizer ändert innerhalb des der Steuereinrichtung St zugeführten Zyklustaktes ZT 90.000 mal seine Frequenz in Stufen von 10 kHz und bestimmt damit die frequenzmäßige Auflösung des Signalspektrums im Bereich zwischen 0,1 und 1 GHz. Der Synthesizer erhält für seine Frequenzstabilisierung als Bezugsfrequenzen die von einem stabilisierten Frequenznormal abgeleiteten Frequenzen Fo=100 MHz, fo=1 MHz, fo'=100 kHz und fo''=10 kHz. Auf der Ausgangsseite weist der Synthesizer noch einen Schalter s auf, der im Zeitbereich des Übergangs von einer Frequenz zur nächsten die Verbindung zum Umsetzer U1 kurzzeitig unterbricht. Auf diese Weise können die mit der Umschaltung bedingten Einschwingvorgänge auf den empfangenen Signalpegel nicht wirksam werden. Der Umsetzer U1 setzt das ihm zugeführte Signal in die erste Zwischenfrequenz von 3,5 GHz um. Dieses Zwischenfrequenzsignal wird dem selektiven Verstärker SV1 zugeführt, dessen selektives Netzwerk eine Bandbreite von 6 MHz aufweist. Insgesamt weist der Verstärker drei Verstärkerstufen auf. Zwischen den ersten beiden Verstärkerstufen befindet sich das bereits erwähnte selektive Netzwerk, zwischen den beiden letzten Verstärkerstufen ist ein regelbares Dämpfungsglied PR1 mit einem Dämpfungsbereich $\Delta$a von 29 dB angeordnet. Das Dämpfungsglied stellt zusammen mit der dritten Verstärkerstufe und dem Regelverstärker einen automatisch arbeitenden Pegelregler dar. Der Regelverstärker RV1 weist eine Ansprechschwelle auf, oberhalb der er das regelbare Dämpfungs glied PR1 von seiner minimalen Dämpfung in Richtung auf seine maximale Dämpfung aussteuert. Weiterhin weist der Regelverstärker RV1 einen zweiten Ausgang auf, über den er mit einem der drei Eingänge des Addierers Ad verbunden ist.

Auf den selektiven Verstärker SV1 folgt ein zweiter Umsetzer U2, der das Zwischenfrequenzsignal bie 3,5 GHz in eine zweite Zwischenfrequenzlage von 10,7 MHz umsetzt. Das Zwischenfrequenzsignal von 10,7 MHz wird dem zweiten selektiven Verstärker SV2 zugeführt, der wie der selektive Verstärker SV1 aufgebaut ist. Das regelbare Dämpfungsglied ist mit PR2 und der Regelverstärker mit RV2 bezeichnet. Ein zweiter Ausgang des Regelver-

**0 002 790**

stärkers ist wiederum mit dem zweiten Eingang des Addierers Ad verbunden. Die Bandbreite b des selektiven Netzwerkes dieses zweiten selektiven Verstärkers SV2 beträgt hier 100 kHz. Nach dem zweiten selektiven Verstärker folgt ein dritter Umsetzer U3, der das Signal in die dritte Zwischenfrequenzlage von 455 kHz umsetzt. Der nachfolgende selektive Verstärker SV3 mit dem einstellbaren Dämpfungsglied PR3 und dem Regelverstärker RV3 ist wiederum in der gleichen Weise aufgebaut wie die beiden anderen selektiven Verstärker. Der zweite Ausgang des Regelverstärkers ist mit dem dritten Eingang des Addierers verbunden. Die Bandbreite b des selektiven Netzwerkes ist hier entsprechend der gewünschten Auflösung auf 10 kHz reduziert. Die Umsetzschwingungen für die weiteren Umsetzer U2 und U3 werden ebenfalls vom Synthesizer Synth erzeugt, sind jedoch im Gegensatz zur Umsetzschwingung für den Umsetzer U1 Festfrequenzen.

Die Regelverstärker RV1, RV2, RV3 haben eine logarithmisch-lineare Charakteristik, so daß am Ausgang des Addierers Ad der Summenwert der Regelgrößen dieser Verstärker, der dem Pegelwert des jeweils ermittelten frequenzmäßigen Signalanteils entspricht, ebenfalls logarithmisch-linear auftritt. Dem Addierer Ad folgt ein Analog-Digitalwandler A/D, dessen digitales Ausgangssignal der Signalpegelauswerte- und Anzeigevorrichtung AA zugeführt wird. Der Addierer Ad, der Analog-Digital-wandler A/D und der Schalter s des Synthesizers Synth werden vom Takt T gesteuert, der dafür sorgt, daß die Übergabe des Summenwertes vom Addierer Ad an den Analog-Digitalwandler A/D immer am Ende eines Frequenzmeßintervalls erfolgt, also in einem Zeitpunkt, in dem die Regelgrößen, insbesondere die Regelgröße des Verstärkers RV3 nicht mehr durch Einschwingvorgänge die durch das selektive Netzwerk des Verstärkers SV3 verursacht werden, beeinträchtigt sind.

In Fig. 2 ist der Pegelverlauf in dBm über dem Ort des Signalzuges nach Fig. 1 aufgetragen und zwar für verschiedene Fälle. Die Kurven MIN und MAX geben den Pegelverlauf an, bei dem am Eingang E der minimale oder der maximale Pegel des zu messenden frequenzmäßigen Signalanteils im Frequenzintervall von 10 kHz auftritt. Die strichpunktierte Linie gibt die Ansprechwelle Vo der Regelverstärker an, auf die hin das Signal am Ausgang A des dritten selektiven Verstärkers SV3 nach Fig. 1 geregelt wird. Der in unterbrochener Linie dargestellte Kurvenverlauf Σ zeigt den Fall an, bei dem in benachbarten Bereichen des gerade ausgewählten Frequenzintervalls von 10 kHz weitere starke Spektrallinien vorhanden sind. Sie kommen natürlich wegen der geringeren Selektivität des ersten und des zweiten selektiven Verstärkers SV1 und SV2 zunächst zum Tragen und werden erst im letzten selektiven Verstärker SV3 unterdrückt.

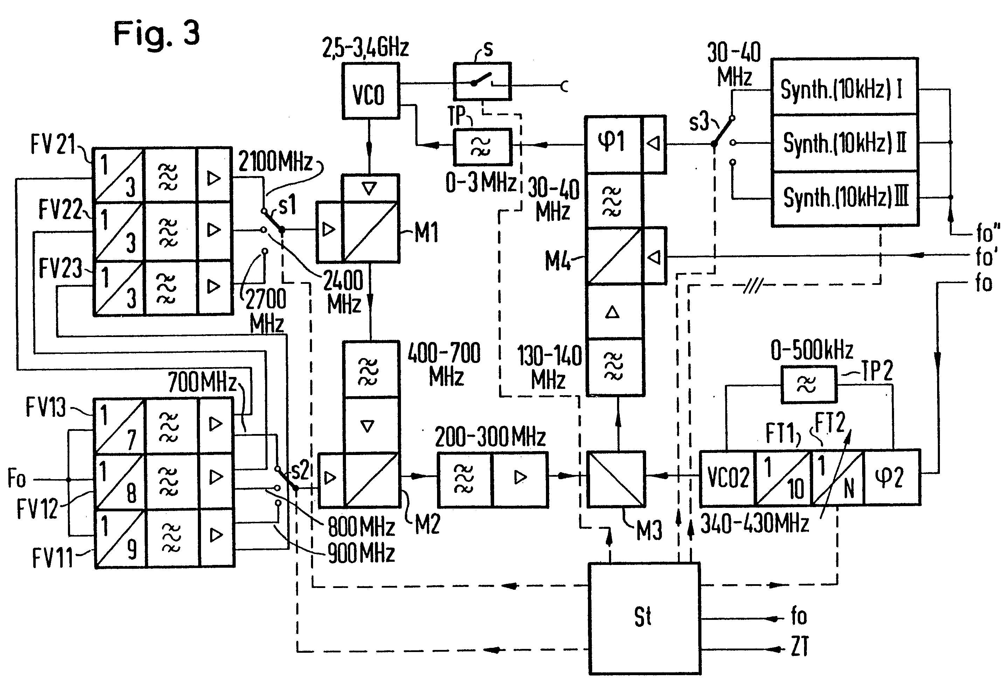

Das nähere Einzelheiten aufweisende Schaltbild des Synthesizers in Fig. 3 zeigt einen steuerbaren Oszillator VCO für den Frequenzbereich von 2,5 bis 3,4 GHz, dessen eigentlicher Ausgang über den in Fig. 1 bereits dargestellten Schalter s mit dem Umsetzer U1 verbunden ist. Die Regelschleife für diesen steuerbaren Oszillator umfaßt insgesamt vier hintereinandergeschaltete Mischer M1 bis M4, einen Phasenvergleicher φ1 und ein Schleifenfilter TP in Form eines Tiefpasses mit einer Grenzfrequenz von 3 MHz. Weiterhin enthält der Synthesizer zwei hintereinander geschaltete Frequenzvervielfacheranordnungen, von denen die erste Frequenzvervielfacheranordnung mit den Frequenzvervielfachern FV11 bis 13 aus der Normalfrequenz Fo die Frequenzen 700, 800 und 900 MHz und die zweite Gruppe von Frequenzvervielfachern mit den Frequenzvervielfachern FV21 bis FV23 die Frequenzen 2100, 2400 und 2700 MHz ableiten. Die Frequenzen 2100, 2400 und 2700 MHz können wahlweise über den Schalter s2 an den Mischer M1 angelegt werden, an dessen ersten Eingang die Ausgangsschwingung des Oszillators VCO ansteht. Die durch diesen Mischer erzeugten Frequenzen zwischen 400 und 700 MHz werden im zweiten Mischer M2 mit einer der über den Schalter s2 anschaltbaren Frequenzen 700, 800 und 900 MHz in den Frequenzbereich von 200 bis 300 MHz heruntergemischt. Der zweite Eingang des dritten Mischers M3 ist mit einem mit einer Phasenregelschleife versehenen Oszillator VC02 verbunden, der den Frequenzbereich von 340 bis 430 MHz überstreicht. Die Phasenregelschleife weist hier einen Frequenzteiler FT1 von 1 zu 10 sowie einen variablen Frequenzteiler FT2, einen Phasenvergleicher φ2 und ein Schleifenfilter TP2 mit einer Grenzfrequenz von 500 kHz auf. Über den Phasenvergleicher φ2, dessen einen Eingang die Normalfrequenz fo zugeführt wird, wird dieser Oszillator quarzstabilisiert. Am Ausgang des Mischers M3 tritt das Frequenzband zwischen 130 und 140 MHz auf, das im Mischer M4, dessen zweiten Eingang die Normalfrequenz fo' zugeführt ist auf 30 bis 40 MHz herabgemischt wird. Im Phasenvergleicher φ1 werden diese Frequenzen zwischen 30 und 40 MHz mit einer der Ausgangsschwingungen der über den Schalter s3 wechselweise anschaltbaren Synthesizer SynthI bis SynthIII verbunden. Die Synthesizer SynthI bis SynthIII sind analog zu dem darunter dargestellten, mit einer Phasenregelschleife versehenen Hilfsoszillator VC02 aufgebaut. Sie unterscheiden sich hiervon lediglich dadurch, daß der feste Frequenzteiler FT1 entfällt und als Bezugsfrequenz jedem dieser Synthesizer die Normalfrequenz fo'' zugeführt wird. Alle drei Synthesizer erzeugen ebenfalls eine Ausgangsschwingung im Frequenzbereich zwischen 30 und 40 MHz und werden über den Schalter s3 stets nacheinander angeschaltet. Die Verdreifachung der Synthesizerschaltung hat hier den Zweck, die relativ große Einschwingzeit ihrer Phasenschleifen dadurch zu umgehen, daß im Zeitpunkt der Anschaltung eines Synthesizers über den Schalter s3 die weiteren Synthesizer bereits auf ihre jeweils nächsten Frequenzen umgestimmt werden können.

Die Gesamtschaltung wird mittels der Steuereinrichtung St, die wiederum mit dem Zyklustakt ZT und der Normalfrequenz fo versorgt wird, so desteuert, daß der Oszillator VCO während eines Zyklusses des Zyklustaktes ZT über den Frequenzbereich von 900 MHz, anfangend von 3,4 GHz in zeitgleichen Stufen von 10 kHz umgeschaltet wird.

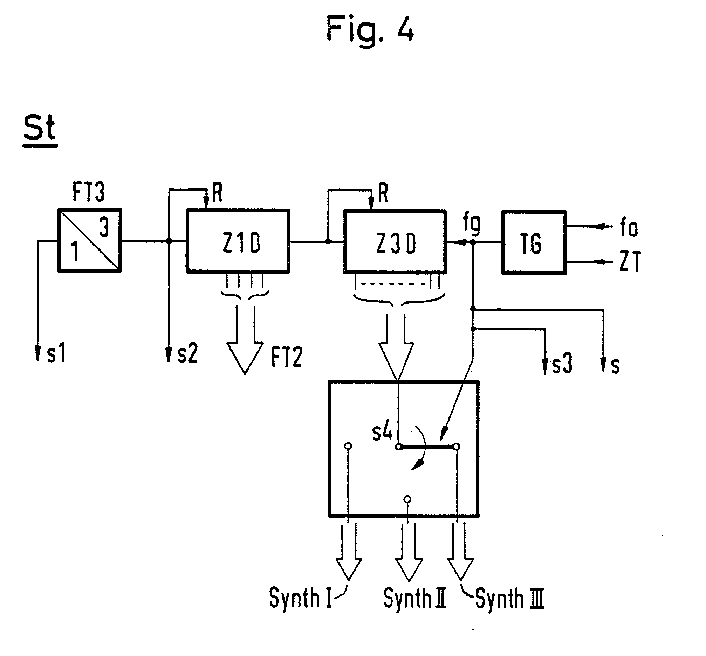

Das in Fig. 4 dargestellte Blockschaltbild der Steuereinrichtung St weist den Taktgenerator TG auf, dem zwei zueinander synchrone Signale, der Zyklustakt ZT und die Normalfrequenz fo zugeführt werden. Hieraus leitet der Taktgenerator eine Schwingung mit der Grundfrequenz fg ab, die bezogen auf das Ausführungsbeispiel des Synthesizers nach Fig. 3 und bei einer angenommenen Zykluszeit von 32 Sek. 2816 Hz beträgt. Damit ergibt sich für die Erzeugung von 90 000 Frequenzwerten innerhalb einer Zykluszeit ein Umschaltzyklus, der im Abstand von in 10 kHz-Stugen aufeinanderfolgenden Frequenzen 355 $\mu$ sec beträgt. Im Rhythmus der Grundfrequenz fg wird der Schalter s kurzzeitig geöffnet um, wie bereits ausgeführt worden ist, die Umschaltzeit des Synthesizers zu überbrücken. Weiterhin wird mit dieser Grundfrequenz fg der Schalter s3 nach Fig. 3 in der Weise gesteuert, daß in diesem Rhythmus die Synthesizer SynthI bis III im ständigen Wechsel an den Phasenvergleicher $\varphi$1 angeschaltet werden.

Dem Ausgang des Taktgenerators TG ist der Dreidekadenzähler Z3D nachgeschaltet, dessen digitalen Ausgänge über den ebenfalls mit der Grundfrequenz fg gesteuerten Schalter s4 wechselweise an die Steuereingänge der Synthesizer SynthI bis III angeschaltet werden. Sobald der Dreidekadenzähler Z3D in seiner Endstellung angelangt ist, gibt er einen Impuls an den ihm nachgeschalteten Eindekadenzähler Z1D ab. Gleichzeitig wird er von diesem Impuls über den Rückstelleingang R wiederum in seine Ausgangsstellung gebracht. Der Eindekadenzähler Z1D steuert über seine Ausgänge digital den variablen Frequenzteiler FT2, der in der Regelschleife des Hilfsoszillators VCO2 angeordnet ist, Sobald der Eindekadenzähler seine Endstellung erreicht hat, gibt er einen Impuls ab, der in dreifacher Weise zur Wirkung kommt. Zum ersten schaltet er über den Rückstelleingang R den Eindekadenzähler Z1D in seine Ausgangsstellung zurück, zum zweiten steuert er den Schalter s2 nach Fig. 3 und zum dritten steuert er den Schalter s1 über den Frequenzteiler FT3 hinweg.

**Patentansprüche**

1. Meßeinrichtung für eine Frequenzanalyse von Signalpegeln innerhalb eines großen Dynamikbereiches, bestehend aus einer Einrichtung zur mehrfachen Umsetzung der Frequenz von Signalen des Eingangsfrequenzbandes mit in Abhängigkeit der Anzahl der Umsetzungen zunehmender Bandbegrenzung in eine Zwischenfrequenzendlage, mit einem die Umsetzerfrequenzen zur durchlaufenden Abtastung eines großen Frequenzbereiches steuerbar erzeugenden Synthesizer, einer in ihrer Verstärkung regelbaren Zwischenverstärkeranordnung und einer Signalpegelauswerte- und -anzeigevorrichtung, dadurch gekennzeichnet, daß zur Durchführung einer extrem schnellen Frequenzanalyse die Zwischenfrequenz-Verstärkeranordnung aus zwei und mehr hintereinander angeordneten, den verschiedenen Umsetzerstufen zugeordneten selektiven Verstärkern (SV1, SV2, SV3) mit zunehmend kleinerer Bandbreite und mit jeweils eigener automatischer, eine Ansprechschwelle aufweisenden Verstärkungsregelung besteht, daß ferner die bei den einzelnen Verstärkern anfallenden Regelgrößen unter Berücksichtigung der vorgegebenen Regelcharakteristiken in einem Addierer (Ad) aufsummiert sind und daß der Summenwert vom Ausgang des Addierers der Signalpegelauswerte- und Anzeigevorrichtung (AA) zugeführt ist.

2. Meßeinrichtung nach Anspruch 1, dadurch gekennzeichnet, daß die Steuerung des Synthesizers (Synth) für eine sprunghafte Frequenzänderung in Stufen erfolgt, deren Größe der Bandbreite des im Zuge der Verstärkung des empfangenen Signalpegels an letzter Stalle vorhandenen selektiven Verstärkers (SV3), die das spektrale Auflösungsvermögen festlegt, angepaßt ist und daß der Summenwert am Ausgang des Addierers (Ad) im Takt des Frequenzwechsels des Synthesizers der Signalpegelauswerte- und Anzeigevorrichtung (AA) zugeführt ist.

3. Meßeinrichtung nach Anspruch 1 oder 2, dadurch gekennzeichnet, daß zwischen den selektiven Verstärkern (SV1, SV2, SV3) weitere mit jeweils einer geeigneten Umsetzschwingung fester Frequenz versorgte Umsetzer (U2, U3) angeordnet sind.

4. Meßeinrichtung nach Anspruch 1 und 2, dadurch gekennzeichnet, daß die Signalpegelauswerte und Anzeigevorrichtung (AA) eingangsseitig einen Analog-Digitalumsetzer (A/D) aufweist, der gleichfalls im Takt des Frequenzwechslers des Synthesizers (Synth) gesteuert ist.

5. Meßeinrichtung nach einem der vorerwähnten Ansprüche, dadurch gekennzeichnet, daß die Regelung der Verstärker (SV1, SV2, SV3) jeweils eine logarithmisch-lineare Charakteristik aufweist und der Addierer (Ad) für eine lineare Summation ausgelegt ist.

6. Meßeinrichtung nach einer der vorhergehenden Ansprüche, dadurch gekennzeichnet, daß die automatische Verstärkungsregelung der selektiven Verstärker (SV1, SV2, SV3) ein zwischen zwei Verstärkerstufen angeordnetes steuerbares Dämpfungsglied (PR1, PR2, PR3) aufweist und daß die das Dämpfungsglied, einen Regelverstarker mit Ansprechschwelle (RV1, RV2, RV3) mit einem zweiten Ausgang für den Addiere (Ad) und eine Verstärkerstufe umfassende Regelschleife breitbandig ausgeführt ist.

**Revendications**

1. Dispositif de mesure pour une analyse de fréquence de niveaux de signaux dans une large gamme dynamique, constitué par un dispositif pour convertir plusieurs fois la fréquence de signaux de la bande de fréquences d'entrée, avec une limitation de bande qui augmente en fonction du nombre de conversions, en une position de fréquence intermédiaire, comprenant un synthétiseur qui produit de façon commandable les fréquences du convertisseur pour l'exploration continue d'une gamme de fréquences importante, un dispositif d'amplification intermédiaire dont le gain est réglable, et un dispositif d'évaluation et d'affichage du niveau des signaux, caractérisé par le fait que pour effectuer une analyse de fréquence extrêmement rapide, le dispositif d'amplification de fréquence intermédiaire est constitué par deux amplificateurs sélectifs, et plus, (SV1, SV2, SV3) montés les uns derrière les autres et associés aux différents étages de conversion et qui possèdent une largeur de bande de plus en plus faible et un réglage automatique du gain qui leur est propre et présente un seuil de réponse, qu'en outre les grandeurs de réglage fournies par les amplificateurs individuels sont additionnées dans un additionneur (Ad) en tenant compte des caractéristiques de réglage prédéterminées et que la valeur de la somme provenent de la sortie de l'additionneur est appliquée au dispositif (A) d'évaluation et d'affichage du niveau des signaux.

2. Dispositif de mesure suivant la revendication 1, caractérisé par le fait que la commande du synthétiseur (Synth) pour une variation de fréquence brusque a lieu en paliers dont la valeur est adaptée à la largeur de bande de l'amplificateur sélectif (SV3) qui se trouve en dernière position sur le trajet de l'amplification du niveau de signal reçu et qui détermine le pouvoir de résolution spectral, et que la somme apparaissant à la sortie de l'additionneur (Ad) est appliquée au dispositif d'évaluation et d'affichage du niveau des signaux (AA), avec la cadence du changement de fréquence du synthétiseur.

3. Dispositif de mesure suivant la revendication 1 ou 2, caractérisé par le fait qu'entre les amplificateurs sélectifs (SV1, SV2, SV3) sont disposés d'autres convertisseurs (U2, U3) respectivement alimentés par une oscillation de conversion appropriée de fréquence fixe.

4. Dispositif de mesure suivant la revendication 1 ou 2, caractérisé par le fait que le dispositif d'évaluation et d'affichage du niveau des signaux (AA) comporte côté entrée un convertisseur analogique-numérique (A/D) qui est également commandé avec la cadence du changement de fréquence du synthétiseur (Synth).

5. Dispositif de mesure suivant l'une des revendications précédentes, caractérisé par le fait que le circuit de réglage des amplificateurs (SV1, SV2, SV3) possède respectivement une caractéristique linéaire logarithmiquement et que l'additionneur (Ad) est conçu pour une sommation linéaire.

6. Dispositif de mesure suivant l'une des revendications précédentes, caractérisé par le fait que le circuit de réglage automatique du gain des amplificateurs sélectifs (SV1, SV2, SV3) comporte un atténuateur commandable (PR1, PR2, PR3) disposé entre deux étages amplificateurs, et que la boucle de réglage qui comprend l'atténuateur, un amplificateur de réglage avec un seuil de réponse (RV1, RV2, RV3) possédant une seconde sortie pour l'additionneur (Ad), et un étage amplificateur, est réalisée avec une large bande.

**Claims**

1. A measuring device for a frequency analysis of signal levels within a large dynamic range, which consists of a device for the repeated conversion of the frequency of signals of the input frequency band with a band limitation increasing in dependence upon the number of the conversions into an intermediate frequency end position, and which has a synthesizer which controllably produces the converter frequency in order to continuously scan a large frequency range, and which has an intermediate amplifier arrangement which can be regulated in respect of its amplification, and which has a signal level analysing and displaying device, characterised in that in order to effect an extremely fast frequency analysis the intermediate frequency amplifier arrangement consists of two and more consecutively arranged selective amplifiers (SV1, SV2, SV3) which are assigned to the different converter stages and have an increasingly smaller band width and each of which have a separate automatic amplification control unit possessing a response threshold, that moreover the regulating variables which occur in the individual amplifiers are added in an adder (Ad) taking into consideration the given regulating characteristics, and that the summation value is fed to the signal level analysing and displaying device (AA) from the output of the adder.

2. A measuring device as claimed in Claim 1, characterised in that the control of the synthesizer (Synth) is effected in stages for a sudden frequency change, whose magnitude is adapted to the band width of the selective amplifier which is present at the last place in the course of the amplification of the received signal level, which last place determines the spectral resolution capacity, and that at the output of the adder (Ad), the summation value is fed to the signal level analysing and displaying device (AA) in the timing of the frequency change of the synthesizer.

3. A measuring device as claimed in Claim 1 or 2, characterised in that between the selective amplifiers (SV1, SV2, SV3), there are arranged further converters (U2, U3) which are each provided with a separate converting oscillation of a fixed frequency.

4. A measuring device as claimed in Claim 1 and 2, characterised in that at the input end, the signal level analysing and displaying device (AA) has an analogue-digital converter (A/D) which is equally controlled in the timing of the frequency change of the synthesizer (Synth).

5. A measuring device as claimed in one of the aforementioned claims, characterised in that the regulation of the amplifiers (SV1, SV2, SV3) has a logarithmic-linear characteristic and the adder (Ad) is designed for a linear summation.

6. A measuring device as claimed in one of the preceding claims, characterised in that the automatic amplification regulation unit of the selective amplifiers (SV1, SV2, SV3) possesses a controllable attenuation element (PR1, PR2, PR3) which is arranged between two amplification stages, and that the regulating loop, which comprises the attenuation element, a regulating amplifier having a response threshold (RV1, RV2, RV3), a second output for the adder (Ad), and an amplifier stage, is designed so as to have a wide band.

0 002 790

Fig. 1

Fig. 2

Fig. 3

# Fig. 4

## St